# EUROPÄISCHE PATENTANMELDUNG

(11) **EP 1 469 515 A2**
(43) Veröffentlichungstag der Anmeldung: **20.10.2004**
(21) Anmeldenummer: 04008140.8
(22) Anmeldetag: 02.04.2004
(51) Int. Cl.: H01L 25/07

(54) **Endstufe zum Ansteuern einer elektrischen Maschine**

(30) Priorität: 02.04.2003 DE 10314951
(71) Anmelder: HILL, Wolfgang, 76135 Karlsruhe (DE)
(72) Erfinder: HILL, Wolfgang, 76135 Karlsruhe (DE)

(57) **Zusammenfassung**

Eine Endstufe (1) zum Ansteuern einer elektrischen Maschine weist mindestens zwei als Halbleiterchips ausgebildete Halbleiterschalter (2a, 2a', 2a", 2b, 2b', 2b") auf, die durch wenigstens einen Brückenleiter (3, 3', 3") zu einer Halbbrücke miteinander verbunden sind. Die Halbleiterschalter (2a, 2a', 2a", 2b, 2b', 2b") kontaktieren jeweils mit einer ihrer Kontaktseiten (4a, 4b) eine elektrische Leiterbahn (5a, 5b) flächig. Die Leiterbahnen (5a, 5b) und der wenigstens eine Brückenleiter (3, 3', 3") sind mit elektrischen Anschlussstellen für die Maschine und/oder eine Stromversorgung verbunden. Der wenigstens eine Brückenleiter (3, 3', 3") ist als Leiterelement ausgebildet ist, das zumindest teilweise in etwa parallel zur Erstreckungsebene einer der Leiterbahnen (5a, 5b) verlaufenden Ebene angeordnet ist. Der wenigstens eine Brückenleiter (3, 3', 3") kontaktiert die Halbleiterschalter (2a, 2a', 2a", 2b, 2b', 2b") an einer ihrer mit den Leiterbahnen (5a, 5b) verbundenen ersten Kontaktseite (4a) gegenüberliegenden zweiten Kontaktseite (4b) flächig.

## Beschreibung

Die Erfindung betrifft eine Endstufe zum Ansteuern einer elektrischen Maschine.

Eine Endstufe zum Ansteuern eines bürstenlosen Elektromotors ist aus der Praxis bekannt. Sie weist mehrere als Transistorchips ausgebildete Halbleiterschalter auf, von denen jeweils zwei durch Bonddrähte und Leiterbahnen zu einer Halbbrücke miteinander verbunden sind. Die Halbleiterschalter sind auf einer Leiterplatte angeordnet, die ein elektrisch isolierendes Substrat aufweist, auf dessen den Halbleiterschaltern zugewandter Oberfläche Leiterbahnen aus Kupfer aufgebracht sind. Die Halbleiterschalter haben an ihren vorderen und hinteren Flachseiten elektrische Kontaktstellen, von denen eine jeweils an der der Leiterplatte zugewandten Rückseite der Halbleiterschalter flächig mit einer Leiterberbahn verbunden ist. An den Kontaktstellen der gegenüberliegenden Vorderseite der Halbleiterschalter sind Bonddrähte über eine Ultraschall-Schweißverbindung angeschlossen. Die Leiterplatte ist an ihrem Außenrand von einem Kunststoffrahmen umgrenzt, der elektrischen Eingangs- und Ausgangsanschlusskontakte zum Verbinden mit einer Motorwicklung und/oder einer Stromversorgung aufweist. Diese Eingangs- und Ausgangsanschlusskontakte sind über Bonddrähte mit den Leiterbahnen der Leiterplatte verbunden. Die Bonddrähte haben einen Durchmesser von etwa 0,3 bis 0,5 mm und weisen deshalb einen relativ großen ohmschen Widerstand auf, der über 1 mQ betragen kann. Damit liegt der elektrische Widerstand der Bonddrähte etwa in der Größenordnung eines niederohmigen Halbleiterschalters, d.h. die Bonddrähte tragen bereits bis zu 50% zum Gesamtwiderstand der Endstufe bei. Bei Elektromotoren mit relativ großen Motorströmen, ergibt sich die Anforderung, den Motorstromkreis und somit auch die Endstufe möglichst niederohmig zu gestalten.

Außerdem hat die Endstufe den Nachteil, dass die Bonddrähte eine relativ große Fläche auf der Leiterplatte benötigen, da sie neben den Halbleiterschaltern Kontaktflächen beanspruchen. Die Leiterplattenfläche der Endstufe beträgt deshalb ein Vielfaches der Chipfläche der Halbleiterschalter. Dadurch wird für die Herstellung der Endstufe auch eine relativ große Menge Leiter- und Isoliermaterial benötigt, was entsprechende Kosten verursacht. Zu diesen Kosten kommen die Kosten für die Bonddrähte noch hinzu. Schließlich ist durch Ultraschallschweißen aber auch nicht immer eine dauerhaft sichere Kontaktierung der Bonddrähte zu gewährleisten.

Es besteht deshalb die Aufgabe, eine Endstufe der eingangs genannten Art zu schaffen, die einen niedrigen ohmschen Widerstand und eine hohe Betriebssicherheit ermöglicht. Außerdem soll die Endstufe kompakte Abmessungen aufweisen und kostengünstig herstellbar sein.

Diese Aufgabe wird mit den Merkmalen des Patentanspruchs 1 gelöst.

In vorteilhafter Weise sind die als ungehäuste Halbleiterchips ausgebildeten Halbleiterschalter jeweils von zwei Seiten flächig mit Leitermaterial kontaktiert. Dadurch ist es möglich, den elektrischen Strom an den Übergangsstellen zwischen den Halbleiterschaltern und dem Leitermaterial sowie beidseits der Halbleiterschalter im Leitermaterial des wenigstens einen Brückenleiters und der Leiterbahnen jeweils in einem relativ großen Querschnitt zu führen, so dass sich insgesamt ein niedriger ohmscher Widerstand und somit entsprechend geringe thermische Verlustleistung in der Endstufe ergeben. Gegenüber einer Endstufe, bei der die Kontaktierung der Halbleiterschalter über Bonddrähte erfolgt, wird außerdem ein wesentlich kompakterer Aufbau Endstufe ermöglicht, da seitlich neben den Halbleiterchips keine Kontaktierungsstellen für die Bonddrähte benötigt werden. Die Verbindung zwischen den Brückenteilen und den Leiterbahnen einerseits und den Halbleiterschaltern andererseits kann durch eine Löt- oder Klebeschicht aus einem elektrisch leitfähigen Werkstoff realisiert sein. Durch die beidseitige flächige Kontaktierung der Halbleiterschalter wird eine große Kontaktierungssicherheit und somit eine entsprechend hohe Betriebssicherheit der Endstufe erreicht.

Bei einer vorteilhaften Ausführungsform der Erfindung sind die Leiterbahnen in derselben Ebene vorzugsweise parallel nebeneinander angeordnet. Durch die parallele Leiterbahnführung ergibt sich ein noch kompakterer Aufbau der Endstufe, bei dem die für die Leiterbahnen benötigte Grundfläche nur etwas größer zu sein braucht als die Summe der Grundflächen der Halbleiterschalter.

Eine noch kleinere Grundfläche der Endstufe kann dadurch erreicht werden, dass die Erstreckungsebenen der Leiterbahnen parallel zueinander beabstandet sind, und dass die Ebene, in welcher der wenigstens eine Brückenleiter angeordnet ist, zwischen diesen Erstreckungsebenen verläuft. Somit ergibt sich ein Schichtstapel, bei dem die Halbleiterschalter, die Leiterbahnen und die Brückenleiter in mindestens fünf Ebenen übereinander angeordnet sind. Diese äußerst kompakte Bauform eignet sich besonders für Endstufen von Stellmotoren, die kurze Einschaltzeiten haben. Die thermischen Verluste werden aufgrund der großen Leiterquerschnitte weitgehend von den Halbleiterschaltern bestimmt.

Bei einer zweckmäßigen Ausgestaltung der Erfindung weist die Endstufe wenigstens zwei Halbbrücken auf, die jeweils einen ersten Halbleiterschalter und einen zweiten Halbleiterschalter haben, die über einen als Leiterelement ausgebildeten, jeweils eine Kontaktseite dieser Halbleiterschalter flächig kontaktierenden Brückenleiter miteinander verbunden sind, derart, dass die Brückenleiter der Halbbrücken in derselben Erstreckungsebene nebeneinander angeordnet sind, und dass die ersten Kontaktseiten der ersten Halbleiterschalter jeweils flächig eine sich durchgängig über die ersten Halbleiterschalter erstreckende erste Leiterbahn und die letzte Kontaktseiten der zweiten Halbleiterschalter jeweils flächig eine sich durchgängig über die zweiten Halbleiterschalter erstreckende zweite Leiterbahn kontaktieren. Über die sich durchgängig über die Halbleiterschalter erstreckenden Leiterbahnen werden dabei jeweils mehrere Halbbrücken mit Strom versorgt, wodurch ein noch kompakterer Aufbau der Endstufe ermöglicht wird.

Vorteilhaft ist, wenn die Brückenteile in ihrer Erstreckungsebene parallel zueinander verlaufen. Dabei sind die Brückenteile quer zu den Leiterbahnen angeordnet. Bei einer vorteilhaften Ausführungsform der Erfindung sind die Leiterbahnen und/oder die Brückenteile als Beschichtung auf mindestens einer elektrisch isolierenden Trägerplatte angeordnet. Dabei kann die Leiterplatte eine kostengünstig herstellbare DCB-Platte sein.

Bei einer bevorzugten Ausführungsform der Erfindung sind die Leiterbahnen und/oder die Brückenteile auf wenigstens einer metallischen Wärmeableitplatte angeordnet, wobei zwischen der Wärmeableitplatte und den Leiterbahnen und/oder Brückenteilen eine elektrisch isolierende Zwischenschicht, vorgesehen ist. Die Wärmeableitplatte ermöglicht dabei über die Zwischenschicht eine großflächige Wärmeableitung von den Halbleiterschaltern beispielsweise in eine mit der Wärmeableitplatte verbundene Halterung.

Vorteilhaft ist, wenn die Leiterbahnen und/oder die Brückenteile plattenförmig ausgebildet sind, und wenn in einer quer zur Erstreckungsebene der Leiterbahnen verlaufenden Richtung die Dicke der Leiterbahnen größer ist als die Dicke der Halbleiterschalter. Die Leiterbahnen und/oder Brückenteile weisen hierdurch eine ausreichende Wärmekapazität auf, um im zyklischen Betrieb Verlustleistungsspitzen abzupuffern.

Bei einer vorteilhaften Ausführungsform der Erfindung ist in der Erstreckungsebene wenigstens eines Halbleiterschalters seitlich neben diesem ein Verpolschutzbaustein und/oder ein Strommessshunt angeordnet, der an seiner einen Kontaktseite flächig mit einer Leiterbahn und an seiner gegenüberliegenden anderen Seite flächig mit mindestens einem etwa in der Erstreckungsebene der Brückenleiter angeordneten Eingangs- oder Ausgangsleiter verbunden ist. Der Verpolschutzbaustein und/oder Strommessshunt sind auf diese Weis platzsparend in die Endstufe integriert.

Vorteilhaft ist, wenn der Strommessshunt zwischen zwei Leiterebenen angeordnet ist. Dadurch ergibt sich eine platzsparende Anordnung des Strommessshunts, bei welcher der Stromfluss in dem Strommessshunt quer und vorzugsweise etwa rechtwinklig zur Erstreckungsebene der Leiterbahn bzw. des Brückenleiters erfolgt. Zum Abgriff des Spannungsabfalls am Strommessshunt können vorzugsweise am stromflussfreien Ende der Leiterbahn, des Brückenleiters und/oder des Anschlussleiters Kontaktlaschen vorgesehen sein.

Auf den aus den Leiterbahnen, den Halbleiterschaltern und dem wenigstens einen Brückenleiter gebildeten Schichtstapel kann als zusätzliche Schicht eine Ansteuerlogik mit ihrer Erstreckungsebene etwa parallel zu den Ebenen der Schichtstapel-Schichten aufgebracht sein, wobei diese Ansteuerlogik über quer zu den Ebenen der Schichtstapel-Schichten verlaufende Leiterteile mit Steuereingängen der Halbleiterschalter verbunden sind. Die Ansteuerlogik weist vorzugsweise ein mehrlagiges Dickschichtsubstrat auf, kann bei Anwendungen mit niedrigen Betriebstemperaturen aber auch als Multilayerplatine ausgeführt sein. Die Leiterteile für die Übertragung der Strom- und/oder Temperaturssignale für die Halbleiterschalter können als Stifte oder Klammern ausgebildet sein.

Vorteilhaft ist, wenn wenigstens eine Leiterbahn und/oder mindestens ein Brückenleiter zwischen der elektrischen Anschlussstelle für die Maschine und/oder die Stromversorgung und einem Halbleiterschalter eine Verformungsstelle aufweist. An den Anschlussstellen auf die Leiterbahnen und/oder Brückenleiter einwirkende mechanische Kräfte sind dann durch die Verformungsstellen von dem jeweils mit dem Halbleiterschalter verbundenen Teil der Leiterbahn bzw. des Brückenleiters entkoppelt.

Vorteilhaft ist, wenn die Ansteuerlogik einen Halbleiterbaustein aufweist, in den eine Signalverarbeitungseinrichtung integriert ist. Dabei ist dieser Halbleiterbaustein vorzugsweise als Mixed-Signal-ASIC in Flip-Chip-Technik ausgebildet. Die Endstufe ermöglicht dann einen noch kompakteren Aufbau. In den Halbleiterbaustein kann mindestens ein Treiber und/oder eine Spannungsversorgung für eine elektrische Schaltung integriert sein.

Nachfolgend sind Ausführungsbeispiele der Erfindung anhand der Zeichnung näher erläutert. Es zeigen:
- Fig. 1: einen Querschnitt durch eine Endstufe mit einer Halbleiterschalter aufweisenden Halbbrücke zum Ansteuern einer elektrischen Maschine,
- Fig. 2: eine Ansicht einer Endstufe, bei der die Halbleiterschalter und die diese kontaktierenden Leiterteile in drei Ebenen übereinander angeordnet sind, und die in einer weiteren Ebene eine Ansteuerlogik für die Halbleiterschalter aufweist,
- Fig. 3 bis 5: Verfahrensschritte, die bei der Montage der in Fig. 2 gezeigten Endstufe durchlaufen werden,
- Fig. 6: eine Ansicht einer Endstufe, bei der die Halbleiterschalter und die diese kontaktierenden Leiterteile in fünf Ebenen übereinander angeordnet sind, und die in einer weiteren Ebene eine Ansteuerlogik für die Halbleiterschalter aufweist,
- Fig. 7: eine Explosionsdarstellung der in Fig. 7 gezeigten Endstufe,
- Fig. 8: eine Aufsicht auf eine Leiterbahn und einen Anschlussleiter, zwischen denen ein Strommessshunt angeordnet ist, wobei die Leiterbahn und der Anschlussleiter nur teilweise dargestellt sind, und
- Fig. 9: eine Seitenansicht der in Fig. 9 gezeigten Messanordnung.

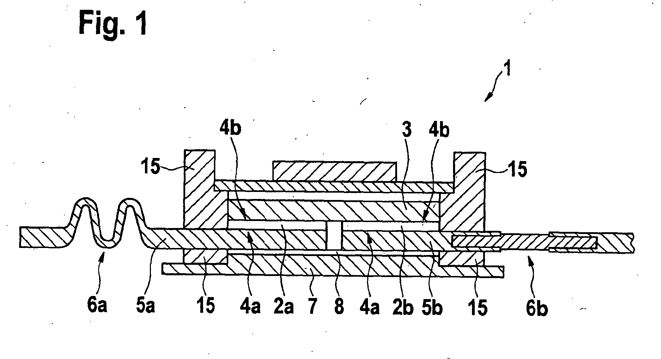

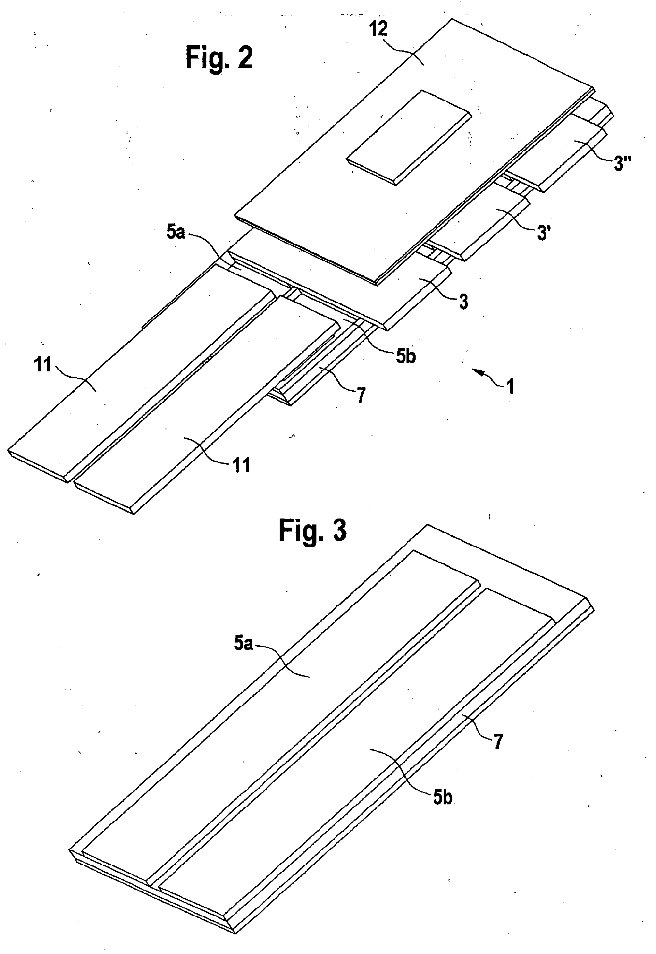

Eine in Fig. 1 und 2 im Ganzen mit 1 bezeichnete Endstufe zum Ansteuern eines bürstenlosen Elektromotors weist mehrere, als gehäuselose als Halbleiterchips ausgebildete Halbleiterschalter 2a, 2a', 2a", 2b, 2b', 2b" auf, von denen jeweils zwei zur Bildung einer Halbbrücke durch einen Brückenleiter 3 miteinander verbunden sind.

Wie in Fig. 1 besonders gut erkennbar ist, sind die Halbleiterschalter 2a, 2a', 2a", 2b, 2b', 2b" an einander abgewandt gegenüberliegenden Kontaktseiten 4a, 4b jeweils flächig von Leitermaterial elektrisch kontaktiert. Ein erster Halbleiterschalter 2a, 2a', 2a" jeder Halbbrücke ist an einer ersten Kontaktseite 4a flächig mit einer ersten Leiterbahn 5a verbunden, die beispielsweise an dem positiven Pol einer elektrischen Stromversorgung angeschlossen sein kann.

An seiner der ersten Kontaktseite 4a abgewandt gegenüberliegenden zweiten Kontaktseite 4b sind die ersten Halbleiterschalter 2a, 2a', 2a" jeweils flächig mit einem Brückenleiter 3, 3', 3" verbunden, der jeweils an einem Anschluss oder einer Phase einer Motorwicklung angeschlossen ist. Die Brückenleiter 3, 3', 3" sind jeweils flächig mit einer zweiten Kontaktseite 4b eines zweiten Halbleiterschalters 2b, 2b', 2b" der betreffenden Halbbrücke verbunden. Die zweiten Halbleiterschalter 2b, 2b', 2b"sind in der Ebene der ersten Halbleiterschalter 2a, 2a', 2a" seitlich neben diesen angeordnet. Als Formteil kann der Brückenleiter auch teilweise quer zur Erstreckungseben verlaufen.

An einer der zweiten Kontaktseite 4b abgewandt gegenüberliegenden ersten Kontaktseite 4a sind die zweiten Halbleiterschalter 2b, 2b', 2b" jeweils flächig mit einer zweiten Leiterbahn 5b verbunden, die beispielsweise an dem negativen Pol oder der Low-Side der elektrischen Stromversorgung angeschlossen sein kann. In Fig. 1 ist erkennbar, dass die Leiterbahnen 5a, 5b zur Vermeidung der Einkopplung mechanischer Kräfte jeweils eine flexible Zone 6a, 6b aufweisen, wobei die Zone 6a durch einen wellenlinienförmigen Leiterbahnenabschnitt und die Zone 6b durch ein Litzendrahtstück gebildet ist.

Eine Wärmeableitplatte 7 kann an einem als Modulrahmen ausgebildeten Gehäuseteil 15 angeordnet sein, das aus einem elektrischen Isolierwerkstoff mit hoher Wärmeleitfähigkeit besteht und der wärmeleitend mit der Wärmeableitplatte 7 verbunden ist. Die Wärmeableitplatte 7 kann etwas über den Rand des Gehäuseteils 15 hinausstehen und so Angriffsflächen bei der Montage und gegebenenfalls durch entsprechende Formgestaltung eine gute Abdichtung beim Umspritzen mit Kunststoff ermöglicht.

Die Verfahrensschritte bei der Fertigung der Endstufe 1 sind in Fig. 2 bis 5 dargestellt. Zunächst werden zwei gerade streifenförmige Leiterbahnen 5a, 5b auf eine Basisplatte aufgebracht, derart, dass sie in etwa parallel zueinander angeordnet und seitlich durch einen Freiraum voneinander beabstandet sind (Fig. 3). Die Basisplatte kann aus einer Wärmeableitplatte 7, wie z.B. einem Kühlblech, und einer thermisch leitenden und elektrisch isolierenden Beschichtung bestehen, die als Zwischenschicht 8 zwischen der Wärmeableitplatte 7 und den Leiterbahnen 5a, 5b angeordnet ist.

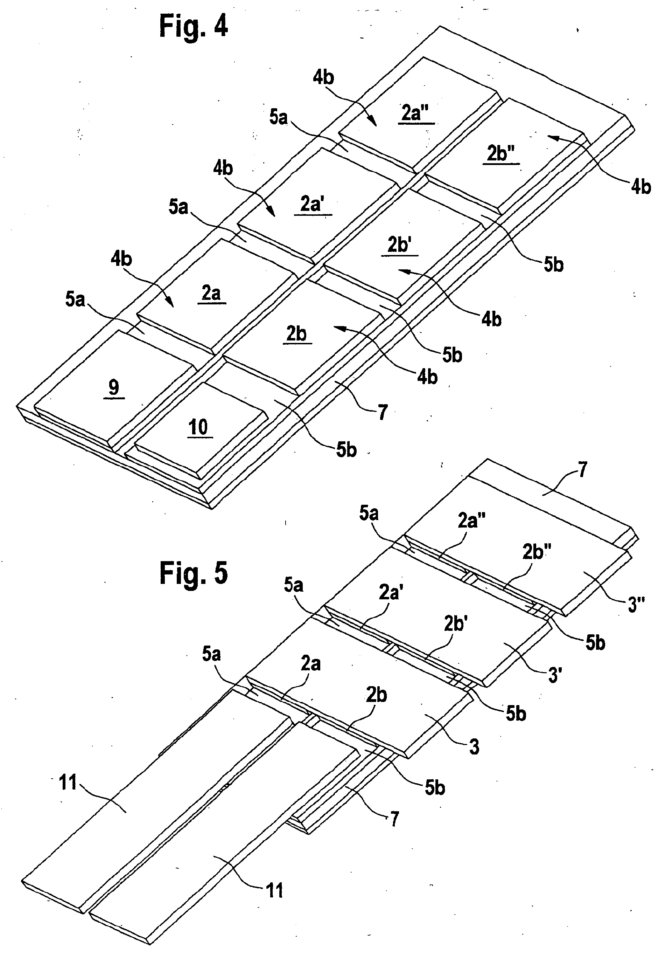

In einem weiteren, in Fig. 4 gezeigten Schritt werden die Halbleiterschalter 2a, 2a', 2a", 2b, 2b', 2b" in zwei sich entlang der Leiterbahnen 5a, 5b nebeneinander erstreckenden Reihen auf den Leiterbahnen 5a, 5b montiert, derart, dass die ersten Halbleiterschalter 2a, 2a', 2a" der Halbbrücken die erste Leiterbahn 5a und die zweiten Halbleiterschalter 2b, 2b', 2b" die zweite Leiterbahn 5b flächig kontaktieren. Außerdem werden auf der einen Leiterbahn 5a, 5b ein als Halbleiterchip ausgebildeter Verpolschutzbaustein 9 und/oder auf der anderen Leiterbahn 5b, 5a ein Strommessshunt 10 jeweils flächig kontaktiert. In Fig. 4 ist erkennbar, dass der Verpolschutzbaustein 9 und der Strommessshunt 10 in der Ebene der Halbleiterschalter 2a, 2a', 2a", 2b, 2b', 2b" seitlich neben diesen angeordnet sind.

In einer weiteren Ebene, die parallel zu der Ebene der Leiterbahnen 5a, 5b verläuft, werden an den zweiten Kontaktseiten 4b der Halbleiterschalter 2a, 2a', 2a", 2b, 2b', 2b" die streifenförmigen Brückenleiter 3, 3', 3" montiert. In Fig. 5 ist erkennbar, dass die Brückenleiter 3, 3', 3" parallel zueinander und quer zur Längserstreckung der Leiterbahnen 5a, 5b verlaufen. Außerdem werden auf dem Verpolschutzbaustein 9 und dem Strommessshunt 10 jeweils ein Eingangs- bzw. Ausgangsleiter 11 flächig kontaktiert. Die Verbindung der Halbleiterschalter 2a, 2a', 2a", 2b, 2b', 2b" mit den Leiterbahnen 5a, 5b und den Brückenleitern 3, 3', 3" kann durch Löten oder Kleben mit elektrisch leitfähigen Werkstoffen oder anderen Fügeverfahren erfolgen. Die Leiterbahnen 5a, 5b und die Brückenleiter 3, 3', 3" werden massiv aus Kupferplatten hergestellt, die eine größere Dicke aufweisen als die Halbleiterschalter 2a, 2a', 2a", 2b, 2b', 2b".

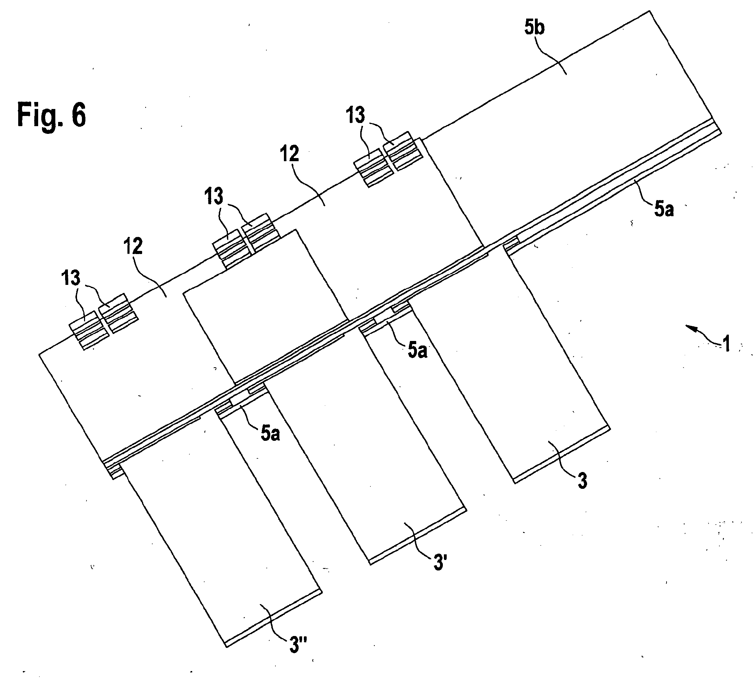

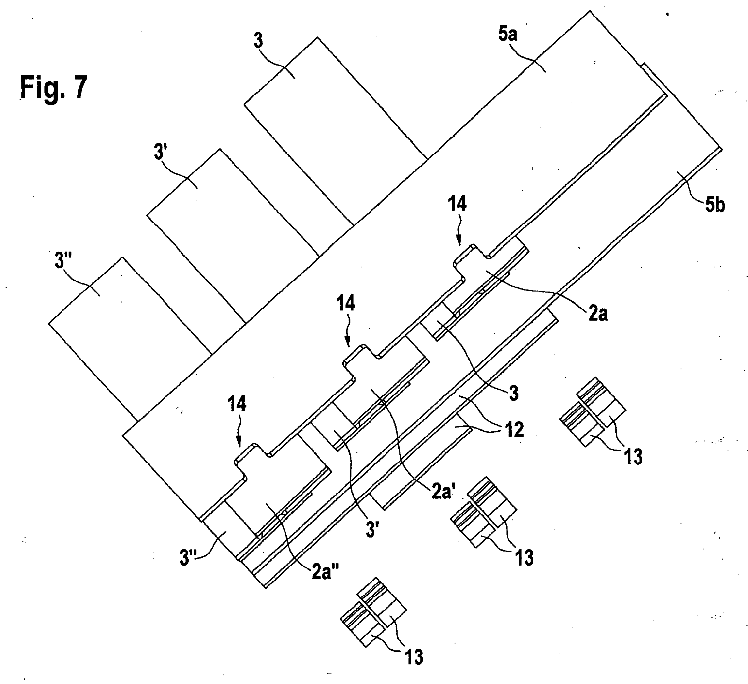

In einem weiteren Schritt wird als Ansteuerlogik an der den Halbleiterschaltern 2a, 2a', 2a", 2b, 2b', 2b" abgewandt gegenüberliegenden Seite der Brückenleiter 3, 3', 3" eine Logikplatte 12 montiert, die etwa parallel zur Ebene der Halbleiterschalter 2a, 2a', 2a", 2b, 2b', 2b" angeordnet ist. Auf der Logikplatte 12 ist ein ASIC 16 angeordnet, der alle Logikfunktionen der Endstufe in sich integriert. Zusätzlich sind lediglich wenige passive Bauteile (Kondensatoren, Widerstände) auf der Logikplatte 12 untergebracht, so dass diese insgesamt sehr kompakt aufgebaut ist. Zur Ansteuerung der Halbleiterschalter 2a, 2a', 2a", 2b, 2b', 2b" ist die Ansteuerlogik über quer zur Ebene der Halbleiterschalter 2a, 2a', 2a", 2b, 2b', 2b" orientierte Leiterteile 13 mit in der Zeichnung nicht näher dargestellten Steuereingängen der Halbleiterschalter 2a, 2a', 2a", 2b, 2b', 2b" verbunden. Bei dem Ausführungsbeispiel nach Fig. 2 sind die Leiterteile 13 als Stifte und bei dem Ausführungsbeispiel nach Fig. 6 und 7 als Klammern ausgebildet.

Bei dem besonders kompakt aufgebauten Ausführungsbeispiel nach Fig. 6 und 7 sind die Leiterbahnen 5a, 5b in unterschiedlichen Ebenen angeordnet, wobei zwischen den Ebenen die ersten Halbleiterschalter 2a, 2a', 2a" und die zweiten Halbleiterschalter 2b, 2b', 2b" sowie die Brückenleiter 3, 3', 3" angeordnet sind. Im Leistungsteil der Endstufe 1 entsteht so ein Aufbau mit fünf Ebenen - drei Leiterebenen und zwei Halbleiterebenen, wobei sich Leiterebenen und Halbleiterebenen quer zur Erstreckungsrichtung der Schichten abwechseln. Für den Durchtritt der mit den Steuereingängen der Halbleiterschalter 2a, 2a', 2a", 2b, 2b', 2b" verbundenen klammerförmigen Leiterteile 13 weisen die Brückenleiter 3, 3', 3" und die zweite Leiterbahn 5b an einem Randbereich Aussparungen 14 auf, wobei dieser Randbereich einer Seite gegenüber liegt, an welcher die Brückenleiter 3, 3', 3" seitlich aus dem Schichtaufbau herausragen. Die klammerförmigen Leiterteile 13 sind etwa U-förmig ausgebildet und drücken mit ihrem einen U-Schenkel jeweils gegen einen Steuereingang (z.B. einen Gatekontakt) eines Halbleiterschalters 2a, 2a', 2a", 2b, 2b', 2b" und mit ihrem anderen U-Schenkel gegen eine Kontaktstelle auf der Logikplatte 12. Aufgrund des mehrschichtigen Aufbaus benötigt die in Fig. 6 und 7 dargestellte Sechser-Brücke für einen bürstenlosen Dreiphasenmotor eine Grundfläche, die kleiner ist als die Summe der sechs Halbleiterschalter 2a, 2a', 2a", 2b, 2b', 2b". Die Kühlung der Halbleiterschalter 2a, 2a', 2a", 2b, 2b', 2b"erfolgt über die freie Oberfläche der zweiten Leiterbahn 5b sowie über Kontaktflächen der Leiterbahnen 5a, 5b und der Brückenleiter 3, 3', 3" zu einem Modulrahmen. Außerdem kann ein direkter Kontakt einer Wärmesenke mit der Logikplatte 12 vorgesehen sein.

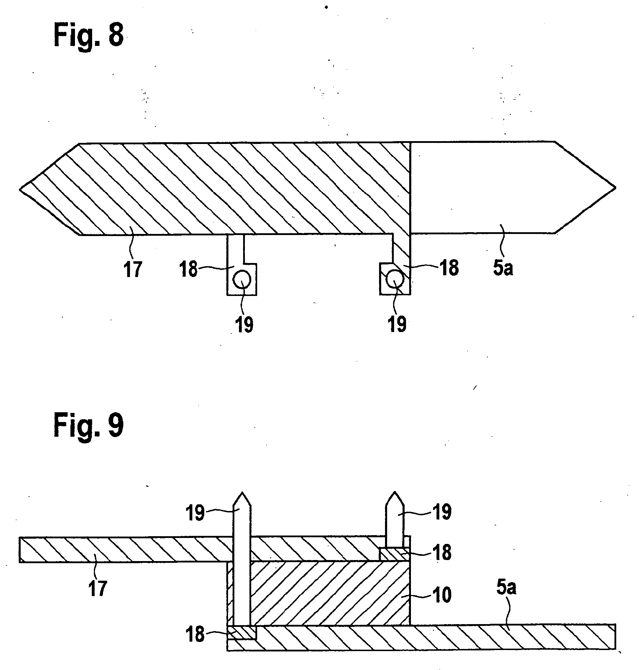

In Fig. 8 und 9 ist erkennbar, dass der Strommessshunt 10 an seinem einen Ende mit einer Leiterbahn 5a, 5b und an seinem anderen Ende mit einem Anschlussleiter 17 verbunden ist. Der Anschlussleiter 17 ist in einer Ebene angeordnet, die etwa parallel zur Ebene der Leiterbahn 5a, 5b verläuft und von dieser beabstandet ist. Zwischen diesen Ebenen ist der Strommessshunt 10 angeordnet, der mit seinem einen Ende die Leiterbahn 5a, 5b und mit seinem anderen Ende den Anschlussleiter 17 kontaktiert. Der Stromfluss in dem Strommessshunt 10 erfolgt quer zu der Ebene der Leiterbahn 5a, 5b und der Ebene des Anschlussleiters 17. Zum Abgriff des elektrischen Spannungsabfalls sind an die nahezu stromlosen Enden der Leiterbahn 5a, 5b und des Anschlussleiters 17 Kontaktlaschen 18 angeformt, die Kontaktstifte 19 tragen.

## Patentansprüche

1. Endstufe (1) zum Ansteuern einer elektrischen Maschine, insbesondere eines bürstenlosen Elektromotors, wobei die Endstufe (1) mindestens zwei als Halbleiterchips ausgebildete Halbleiterschalter (2a, 2a', 2a", 2b, 2b', 2b") aufweist, die durch wenigstens einen Brückenleiter (3, 3', 3") zu einer Halbbrücke miteinander verbunden sind, wobei die Halbleiterschalter (2a, 2a', 2a", 2b, 2b', 2b") jeweils mit einer ihrer Kontaktseiten (4a, 4b) eine elektrische Leiterbahn (5a, 5b) flächig kontaktieren und der wenigstens eine Brückenleiter (3, 3', 3") die Halbleiterschalter (2a, 2a', 2a", 2b, 2b', 2b") an einer ihrer mit den Leiterbahnen (5a, 5b) verbundenen ersten Kontaktseite (4a) gegenüberliegenden zweiten Kontaktseite (4b) flächig kontaktiert.

2. Endstufe (1) nach Anspruch 1, **dadurch gekennzeichnet, dass** der wenigstens eine Brückenleiter (3, 3', 3") als Leiterelement ausgebildet ist und mit elektrischen Anschlussstellen für die Maschine verbunden ist.

3. Endstufe (1) nach Anspruch 1 oder 2, **dadurch gekennzeichnet, dass** die Erstreckungsebenen der Leiterbahnen (5a, 5b) parallel zueinander beabstandet sind, und dass die Ebene, in welcher der wenigstens eine Brückenleiter (3, 3', 3") angeordnet ist, zwischen diesen Erstreckungsebenen verläuft.

4. Endstufe (1) nach einem der Ansprüche 1 bis 3, **dadurch gekennzeichnet, dass** sie wenigstens zwei Halbbrücken aufweist, die jeweils einen ersten Halbleiterschalter (2a, 2a', 2a") und einen zweiten Halbleiterschalter (2b, 2b', 2b") haben, die über einen als flächiges Leiterelement ausgebildeten, jeweils die zweiten Kontaktseiten (4b) dieser Halbleiterschalter (2a, 2a', 2a", 2b, 2b', 2b") flächig kontaktierenden Brückenleiter (3, 3', 3") miteinander verbunden sind, derart, dass die Brückenleiter (3, 3', 3") der Halbbrücken nebeneinander angeordnet sind, und dass die ersten Kontaktseiten (4a) der ersten Halbleiterschalter (2a, 2a', 2a") jeweils flächig eine sich durchgängig über die ersten Halbleiterschalter (2a, 2a', 2a") erstreckende erste Leiterbahn (5a) und die letzten Kontaktseiten (4a) der zweiten Halbleiterschalter (2b, 2b', 2b") jeweils flächig eine sich durchgängig über die zweiten Halbleiterschalter (2b, 2b', 2b") erstreckende zweite Leiterbahn (5b) kontaktieren.

5. Endstufe (1) nach einem der Ansprüche 1 bis 4, **dadurch gekennzeichnet, dass** die Leiterbahnen (5a, 5b) und/oder die Brückenteile (3, 3', 3") als Beschichtung auf mindestens einer elektrisch isolierenden Trägerplatte angeordnet sind.

6. Endstufe (1) nach einem der Ansprüche 1 bis 5, **dadurch gekennzeichnet, dass** die Leiterbahnen (5a, 5b) und/oder die Brückenteile (3, 3', 3") auf wenigstens einer metallischen Wärmeableitplatte (7) angeordnet sind, und dass zwischen der Wärmeableitplatte (7) und den Leiterbahnen (5a, 5b) und/oder Brückenteilen (3, 3', 3") eine elektrisch isolierende Zwischenschicht (8) vorgesehen ist.

7. Endstufe (1) nach einem der Ansprüche 1 bis 8, **dadurch gekennzeichnet, dass** in der Erstreckungsebene wenigstens eines Halbleiterschalters (2a, 2a', 2a", 2b, 2b', 2b") seitlich neben diesem ein Verpolschutzbaustein (9) und/oder ein Strommessshunt (10) angeordnet ist, der an seiner einen Kontaktseite flächig mit einer Leiterbahn (5a, 5b) und an seiner gegenüberliegenden anderen Seite flächig mit mindestens einem etwa in der Erstreckungsebene der Brückenleiter (3, 3', 3") angeordneten Eingangs- oder Ausgangsleiter (11) verbunden ist.

8. Endstufe nach einem der Ansprüche 1 bis 7, **dadurch gekennzeichnet, dass** der Strommessshunt (10) an seinem einen Ende mit einer Leiterbahn (5a, 5b) oder einem Brückenleiter (3, 3', 3") und an seinem anderen Ende mit einem Anschlussleiter verbunden ist, und dass die Verbindungsstelle, an der die Leiterbahn (5a, 5b) oder der Brückenleiter (3, 3', 3") den Strommessshunt (10) kontaktiert, von der Verbindungsstelle, an welcher der Anschlussleiter den Strommessshunt (10) kontaktiert, quer zur Erstreckungsebene der Leiterbahn (5a, 5b) oder des Brückenleiters (3, 3', 3") voneinander beabstandet sind.

9. Endstufe nach einem der Ansprüche 1 bis 8, **dadurch gekennzeichnet, dass** auf den aus den Leiterbahnen (5a, 5b), den Halbleiterschaltern (2a, 2a', 2a", 2b, 2b', 2b") und dem wenigstens einen Brückenleiter (3, 3', 3") gebildeten Schichtstapel als zusätzliche Schicht eine Ansteuerlogik mit ihrer Erstreckungsebene etwa parallel zu den Ebenen der Schichtstapel-Schichten aufgebracht ist, dass diese Ansteuerlogik über quer zu den Ebenen der Schichtstapel-Schichten verlaufende Leiterteile (13) mit Steuereingängen der Halbleiterschalter (2a, 2a', 2a", 2b, 2b', 2b") verbunden sind und dass die Ansteuerlogik einen Halbleiterbaustein aufweist, der als Mixed-Signal-ASIC (16) in Flip-Chip-Technik ausgebildet die Signalverarbeitungseinrichtung weitgehend integriert und der auf einer mehrlagigen Dickschichtkeramik oder einer Multilayerplatine angeordnet ist .

10. Endstufe (1) nach einem der Ansprüche 1 bis 9, **dadurch gekennzeichnet, dass** wenigstens eine Leiterbahn (5a, 5b) und/oder mindestens ein Brückenleiter (3, 3', 3") zwischen der elektrischen Anschlussstelle für die Maschine und/oder die Stromversorgung und einem Halbleiterschalter (2a, 2a', 2a", 2b, 2b', 2b") eine Verformungsstelle aufweist.
